# EUROPEAN PATENT APPLICATION

(11) **EP 3 882 985 A1**
(43) Date of publication of application: **22.09.2021**
(21) Application number: 20163648.7
(22) Date of filing: 17.03.2020
(51) Int. Cl.: H01L 31/054, H01L 31/048, B60J 7/043, B60Q 3/208, B60Q 3/64, H01L 33/00

(54) **ASSEMBLY OF A PANEL AND AT LEAST ONE LIGHT DEVICE AND OPEN ROOF CONSTRUCTION PROVIDED THEREWITH**

(71) Applicant: Inalfa Roof Systems Group B.V., 5807 GW Oostrum (NL)
(72) Inventor: Doleweerd, van, Theodorus, 6024AK Budel-Dorplein (NL); Bie, de, Sander, 6361XB Nuth (NL)
(74) Representative: De Vries & Metman

(57) **Abstract**

An assembly of a panel (1) made of a transparent material and at least one light device (2) for at least one of emitting light into the panel and receiving light from the panel is provided, wherein the panel comprises two opposite main surfaces (3,4) and side edge surfaces (5) connecting the main surfaces and wherein the light device is positioned adjacent at least one of the side edge surfaces. Regions of both main surfaces (3,4) of the panel adjacent said at least one side edge surface (5) where the light device (2) is positioned are provided with light reflecting means (11,12) intended for reflecting light travelling inside the panel.

## Description

The invention firstly relates to an assembly of a panel made of a transparent material and at least one light device for at least one of emitting light into the panel and receiving light from the panel, wherein the panel comprises two opposite main surfaces and side edge surfaces connecting the main surfaces and wherein the light device is positioned adjacent at least one of the side edge surfaces.

Known assemblies of such a type may suffer from drawbacks such as (especially in the case of emitting light into the panel) a loss (for example absorption) of light in regions of the panel close to the side edge surfaces and artefacts in the light appearance, leading to a less homogeneous final light appearance and such as (especially in the case of receiving light from the panel) a reduction of the intensity of light leaving the panel (for example for cooperation with solar cells). The manner of attaching the panel and badly aligned light devices (for example LEDs) relative to a curvature of the side edge surfaces are some of the causes of such drawbacks.

It is an object of the present invention to provide an improved assembly.

In accordance with the present invention the assembly is characterized in that regions of both main surfaces of the panel adjacent said at least one side edge surface where the light device is positioned are provided with light reflecting means intended for reflecting light travelling inside the panel. Due to the provision of such light reflecting means at said region of both main surfaces, the loss of light in said region can be reduced or substantially prevented. The final light appearance (in case of the emission of light into the panel) will be more homogeneous, whereas (in case of receiving light from the panel) the light yield will be increased.

It is noted that the transparent material from which the panel is made in most cases will be glass or a plastic material (and may be monolithic but also may comprise a laminated assembly of any appropriate type).

The reflecting means may come in many different embodiments. In one embodiment the light reflecting means comprise reflecting layers attached to the main surfaces.

Such reflecting layers may comprise at least one of a mirror coating, a metal foil (or similar reflecting layer which reflects per se) or a layer of a material of which the refractive index is smaller than the refractive index of the material of the panel (which causes a total internal reflection in the panel). Also, combinations of such embodiments are conceivable (depending on the circumstances it even is conceivable that different ones of said embodiments are used at different parts of said regions of both main surfaces of the panel adjacent said at least one side edge surface where the light device is positioned).

Although preferably the light reflective layers on both main surfaces of the panel are made of the same material, there may be situations in which the reflective layers differ. More generally the light reflective means of both main surfaces may or may not differ.

In an embodiment the assembly according to the present invention comprises an additional panel made of a transparent material positioned on top of one of the reflective layers, wherein said reflective layer simultaneously acts as a bonding agent for bonding the additional panel to the panel. In such an embodiment it is conceivable that said reflective layer extends substantially over the entire region of overlap between the panel and the additional panel.

In an embodiment at least some of the reflecting layers comprise high cross link density ethylene-vinyl acetate (HEVA). This material offers a high temperature stability as well as a stability of adhesion (a covalent bonding to the surface of the panel main surface).

In an embodiment of the assembly the light device comprises an array of LEDs for emitting light into the panel. However, the use of such a (substantially homogeneous) light in-coupling system may still lead to a partly inhomogeneous light appearance. For example, front and rear corners of the panel may show lower light intensities, and misalignments of the LEDs with respect to the panel also may cause a (local) reduction in light intensity. Thus, for improving the light appearance (and specifically its homogeneity), a number of specific embodiments may be implemented when using LEDs. For example the LEDs may be configured such that at least some LEDs in the array of LEDs emit light with different intensities and/or the LEDs may be configured such that at least some LEDs in the array of LEDs have different orientations for emitting light into the panel in different directions and/or the spacing between at least some LEDs in the array of LEDs may vary.

In embodiments in which the LEDs only are positioned adjacent some of the side edge surfaces of the panel the side edge surfaces of the panel adjacent which no LEDs are positioned may be provided with a reflective layer (preferably of the type reflecting per se), thus further improving the homogeneity of the light appearance.

In a specific embodiment of the assembly the panel at its side edge surfaces is provided with an encapsulation which partially overlaps at least one main surface of the panel, wherein the light reflecting means at said main surface at least extends over the region of overlap between the main surface and the encapsulation.

In yet another embodiment the panel at at least one of its side edge surfaces is provided with a cover that is attached to a main surface of the panel and that partially overlaps the panel, wherein the light reflecting means at said main surface at least extends over the region of overlap between said main surface and the cover and is positioned between said main surface and the cover.

In another embodiment the light device comprises at least one solar cell, preferably an array of solar cells, for receiving light from the panel, wherein the panel comprises fluorophores, preferably quantum dots, for transforming incident sun light into light travelling through the panel towards the at least one solar cell.

In a preferred embodiment of the assembly according to the present invention, the panel has a substantially rectangular shape with a forward, a rearward and two transverse side edge surfaces and wherein light devices are positioned adjacent the forward and rearward side edge surfaces, or adjacent the two transverse side edge surfaces or at the forward, rearward and transverse side edge surfaces.

It is noted that during manufacturing of a panel the side edge surfaces often are rounded for removing cracks and for preventing that such cracks propagate into the panel. However, such rounded side edge surfaces may cause discontinuities (such as stripes) in the light appearance. Thus, it is preferred that the side edge surfaces are not rounded but are flat.

In a second aspect the invention relates to an open roof construction for a vehicle having a roof opening in a stationary roof part and a panel for closing said roof opening, wherein said panel is part of an assembly according to the present invention.

Hereinafter the invention will be elucidated while referring to the drawing, in which:
Figure 1 schematically illustrates part of a cross-section of an embodiment of the assembly according to the invention;
Figures 2-4 schematically illustrate parts of a number of embodiments with different arrangements of LEDs in a top plan view;
Figure 5 schematically illustrates part of another embodiment of an assembly in a top plan view;
Figure 6 schematically illustrates part of a cross-section of another embodiment of the assembly, and
Figure 7 schematically illustrates a vehicle comprising an assembly according to the invention.

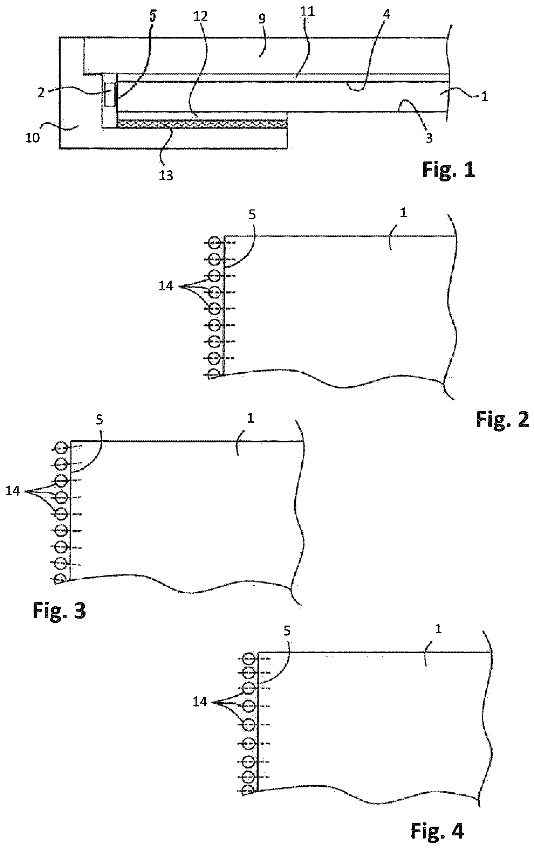

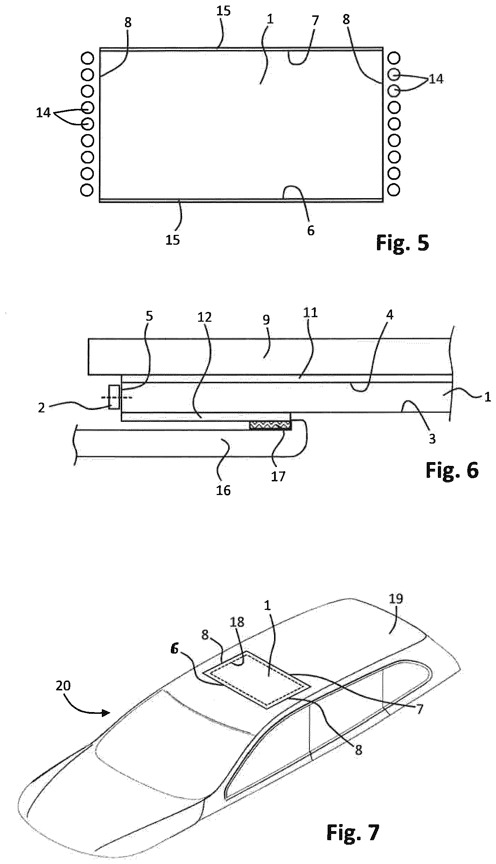

In figure 1 an assembly of a panel 1 made of a transparent material (such as, for example, a monolithic or laminated glass panel) and at least one light device 2 (in this embodiment an array of LEDs for emitting light into the panel) is illustrated in a cross-sectional view. The panel 1 comprises two opposite main surfaces 3 and 4 and side edge surfaces 5 (only one of which is illustrated in this view) connecting the main surfaces 3 and 4. The light device 2 is positioned adjacent the illustrated side edge surface 5. In a practical embodiment, in which the panel 1 has a substantially rectangular shape with a forward side edge surface 6, a rearward side edge surface 7 and two transverse side edge surfaces 8 (see for example figure 7) such light devices 2 for example may be positioned adjacent the forward and rearward side edge surfaces 6,7, or adjacent the two transverse side edge surfaces 8 or at the forward, rearward and transverse side edge surfaces 6,7,8 (without, however, excluding the possibility of a position at a single side edge surface only).

In the embodiment shown in figure 1 the assembly further comprises an additional panel 9 made of a transparent material (e.g. glass) positioned on top of the panel 1. The panel 1 and additional panel 9 are (at least at some, and preferentially at all side edge surfaces) encapsulated in an encapsulation 10 which partially overlaps at least one main surface 3 of the panel 1 (and which in the illustrated embodiment also defines a support for the light device 2).

Between the panel 1 and the additional panel 9 a first reflective layer 11 is positioned (on the main surface 4) intended for reflecting light travelling inside the panel 1 which simultaneously acts as a bonding agent for bonding the additional panel 9 to the panel 1. Generally said first reflective layer 11 will extend substantially over the entire region of overlap between the panel 1 and the additional panel 9 (and preferably over the entire main surface 4).

At least a region of both main surfaces 3 and 4 of the panel 1 adjacent said at least one side edge surface 5 where the light device 2 is positioned are provided with a reflective layer intended for reflecting light travelling inside the panel 1. This means that in said region apart from the first reflective layer 11 (which also extends beyond said regions) a second reflective layer 12 is provided on the main surface 3 intended for reflecting light travelling inside the panel. In the illustrated embodiment the second reflective layer 12 extends over the region of overlap between the main surface 3 and the encapsulation 10 (but in other embodiments not shown it may extend over a smaller or larger region).

Between the encapsulation 10 and the panel 1 often a layer 13 of a black primer or a black ceramic is provided, and in such a case the second reflective layer 12 will be positioned between such a layer 13 and the panel 1.

The reflective layers 11 and 12 may be positioned on/attached to the main surfaces 3 and 4 in any convenient manner and may comprise at least one of a mirror coating or a metal foil (or similar reflecting layer which reflects per se) or a layer of a material of which the refractive index is smaller than the refractive index of the material of the panel 1 (which causes a total internal reflection in the panel). The reflective layers 11 and 12 on both main surfaces 3 and 4 of the panel 1 may or may not be made of the same material. It is also possible to provide different reflecting means on the main surfaces.

In an alternative embodiment not illustrated the additional panel 9 is not provided, but the first reflective layer also in such a case will be present, albeit that the first reflective layer 11 may then not extend over the entire main surface 4.

In figure 2 an embodiment is illustrated in which at the respective side edge surface 5 an array of LEDs 14 is provided acting as the light device 2 for emitting light into the panel 1. In this embodiment the individual LEDs 14 of the array are positioned equidistantly and emit light in parallel directions (indicated schematically by the dotted lines).

However, to cope with and compensate for any inhomogeneous light appearance in the panel 1, the LEDs may be arranged in different configurations along such a side edge surface 5, as illustrated in figures 3 and 4. In an embodiment according to figure 3 the LEDs again are positioned equidistantly but emit the light in varying directions (not all dotted lines extend in parallel to each other). In an embodiment according to figure 4 the LEDs emit the light in parallel directions, but the LEDs are positioned at varying spacings. Any combination of these features is possible too. In addition, it is also conceivable that the LEDs 14 are configured such that at least some LEDs in the array of LEDs emit light with different intensities.

In figure 5 a panel 1 is illustrated wherein the LEDs 14 only are positioned adjacent some of the side edge surfaces (here for example opposite transverse side edge surfaces 8) of the panel and wherein the remaining side edge surfaces (here forward and rearward side edge surfaces 6 and 7) of the panel 1 (adjacent which no LEDs 14 are positioned) are provided with a reflective layer 15 (in addition to the first and second reflective layers 11,12 which are provided but are not visible in figures 2-5).

Referring to figure 6 an embodiment is illustrated in which the panel 1 at at least one of its side edge surfaces 5 is provided with a cover 16 that is attached to a main surface 3 of the panel (for example using a pressure sensitive adhesive tape 17) and that partially overlaps the panel 1. The second reflective layer 12 at said main surface 3 at least extends over the region of overlap between said main surface 3 and the cover 16 and is positioned between said main surface and the cover.

Whereas in the above the light device 2 is embodied as an array of LEDs 14 emitting light into the panel 1, it also conceivable that the light device 2 comprises at least one solar cell, preferably an array of solar cells (which in the figures likewise could be indicated by the reference numbers 14), for receiving light from the panel and wherein the panel could comprise fluorophores, preferably quantum dots, for transforming incident sun light into light travelling through the panel towards the at least one solar cell for generating electric power.

Finally, figure 7 schematically illustrates part of a vehicle 20 having a roof opening 18 in a stationary roof part 19 and a panel 1 for closing said roof opening, wherein said panel is part of an assembly according to the present invention. The panel 1 may have a stationary position, but may also be movable for opening the roof opening 18, as is known per se.

The invention is not limited to the embodiments described above which may be varied widely within the scope of the invention as defined by the appending claims.

## Claims

1. Assembly of a panel (1) made of a transparent material and at least one light device (2) for at least one of emitting light into the panel and receiving light from the panel, wherein the panel comprises two opposite main surfaces (3,4) and side edge surfaces (5) connecting the main surfaces and wherein the light device is positioned adjacent at least one of the side edge surfaces, **characterized in that** regions of both main surfaces (3,4) of the panel (1) adjacent said at least one side edge surface (5) where the light device (2) is positioned are provided with light reflecting means (11,12) intended for reflecting light travelling inside the panel.

2. Assembly according to claim 1, wherein the light reflecting means comprise reflecting layers (11,12) attached to the main surfaces (3,4).

3. Assembly according to claim 2, wherein the reflecting layers (11,12) comprise at least one of a mirror coating, a metal foil or a layer of a material of which the refractive index is smaller than the refractive index of the material of the panel (1).

4. Assembly according to claim 2 or 3, wherein the reflective layers (11,12) on both main surfaces (3,4) of the panel (1) are made of the same material.

5. Assembly according to any of the claims 2-4, comprising an additional panel (9) made of a transparent material positioned on top of one of the reflective layers (11), wherein said reflective layer simultaneously acts as a bonding agent for bonding the additional panel to the panel (1).

6. Assembly according to claim 5, wherein said reflective layer (11) extends substantially over the entire region of overlap between the panel (1) and the additional panel (9).

7. Assembly according to any of the claims 2-6, wherein at least some of the reflecting layers (11,12) comprise high cross link density ethylene-vinyl acetate (HEVA).

8. Assembly according to any of the previous claims, wherein the light device (2) comprises an array of LEDs (14) for emitting light into the panel (1).

9. Assembly according to claim 8, wherein the LEDs (14) are configured such that at least some LEDs in the array of LEDs emit light with different intensities and/or that the LEDs are configured such that at least some LEDs in the array of LEDs have different orientations for emitting light into the panel (1) in different directions and/or that the spacing between at least some LEDs in the array of LEDs varies.

10. Assembly according to claim 8 or 9, wherein the LEDs (14) only are positioned adjacent some of the side edge surfaces (5) of the panel (1) and wherein the side edge surfaces of the panel adjacent which no LEDs are positioned are provided with a reflective layer (15).

11. Assembly according to any of the previous claims, wherein the panel (1) at its side edge surfaces (5) is provided with an encapsulation (10) which partially overlaps at least one main surface (3) of the panel and wherein the light reflecting means (12) at said main surface (3) at least extends over the region of overlap between the main surface (3) and the encapsulation.

12. Assembly according to any of the claims 1-10, wherein the panel (1) at at least one of its side edge surfaces (5) is provided with a cover (16) that is attached to a main surface (3) of the panel and that partially overlaps the panel and wherein the light reflecting means (12) at said main surface at least extends over the region of overlap between said main surface and the cover and is positioned between said main surface and the cover.

13. Assembly according to any of the claims 1-7, wherein the light device (2) comprises at least one solar cell, preferably an array of solar cells, for receiving light from the panel and wherein the panel comprises fluorophores, preferably quantum dots, for transforming incident sun light into light travelling through the panel towards the at least one solar cell.

14. Assembly according to any of the previous claims, wherein the panel (1) has a substantially rectangular shape with a forward (6), a rearward (7) and two transverse (8) side edge surfaces and wherein light devices (2) are positioned adjacent the forward and rearward side edge surfaces, or adjacent the two transverse side edge surfaces or at the forward, rearward and transverse side edge surfaces.

15. Open roof construction for a vehicle (20) having a roof opening (18) in a stationary roof part (19) and a panel (1) for closing said roof opening, wherein said panel is part of an assembly according to any of the previous claims.
